# EUROPEAN PATENT APPLICATION

(11) **EP 4 539 626 A1**
(43) Date of publication of application: **16.04.2025**
(21) Application number: 23819764.4
(22) Date of filing: 02.06.2023
(51) Int. Cl.: H05K 9/00, H01F 27/36, H01L 23/00

(54) **ELECTRONIC COMPONENT UNIT**

(30) Priority: 08.06.2022 JP 2022093038
(71) Applicant: Tamura Corporation, Tokyo 178-8511 (JP)
(72) Inventor: SAITO, Shoichi, Sakado-shi, Saitama 350-0214 (JP); AOKI, Hirotoshi, Sakado-shi, Saitama 350-0214 (JP); MOMMA, Akio, Sakado-shi, Saitama 350-0214 (JP); SAITO, Takahide, Iruma-shi, Saitama 358-0032 (JP); DATE, Tenyu, Iruma-shi, Saitama 358-0032 (JP); KITAMURA, Akira, Iruma-shi, Saitama 358-0032 (JP); KUMAKURA, Ichiro, Iruma-shi, Saitama 358-0032 (JP); OSHIMA, Yasuo, Sakado-shi, Saitama 350-0214 (JP)
(74) Representative: Plougmann Vingtoft a/s
(86) International application number: PCT/JP2023/020583
(87) International publication number: WO 2023/238784

(57) **Abstract**

To provide an art capable of enhancing the quality of an electronic component unit.

A shield layer 50 is placed on a first surface 11a, a second surface 12a, or a third surface 13a of a case 10 of an electronic component unit (current sensor). For the shield layer 50, various pastes (a carbon paste and a magnetic paste) are adopted. Capable of freely coating a desired place, the pastes can form an appropriate shielding structure, making it possible to easily improve both a dV/dt characteristic and an EMC characteristic. Further, adding the magnetic paste enables the shielding of a radio noise band (a frequency band of around 0.1 to 5.0 MHz). Further, being formed of the pastes, the shield layer 50 can be formed at a lower cost than a metal shield (film formed by vacuum deposition such as vapor deposition or sputtering).

## Description

### [Technical Field]

The present invention relates to an electronic component unit having an electronic component.

### [Background Art]

Patent Document 1 discloses a current sensing device having an electrical shield. In Patent Document 1, it is described that "the electrical shield is preferably made from a conductive material, such as a metal material, a doped semiconductor material, or graphite".

### [Prior Art Document]

### [Patent Document]

[Patent Document 1] Japanese Unexamined Patent Application Publication No. 2022-23824

### [Summary of Invention]

### [Problem to be Solved by Invention]

In an electronic component unit such as the aforesaid current sensing device, quality enhancement is desired.

Under such circumstances, it is an object of the present invention to provide an art capable of enhancing the quality of an electronic component unit.

### [Solution to Problem]

The present invention adopts the following solutions to solve the aforementioned problem. It should be noted that terms in the following solutions and parentheses are only examples and the present invention is not limited by these. Further, the present invention can be an invention including at least one of the subject matters presented in the following solutions. Further, the subject matters presented in the following solutions each can have a more specific concept by an element limiting the subject matter being added and can also have a more generic concept by an element limiting the subject matter being deleted.

Solution 1: An electronic component unit of this solution is an electronic component unit including: an electronic component; a case in which the electronic component is housed; and a shield layer placed on at least part of a surface on an inner side of the case and having conductivity and magnetism,

The electronic component unit of this solution has the following configurations.
(1) It includes an electronic component. The electronic component is an electronic element necessary for the electronic component unit. The electronic component is, for example, a core, a substrate, or the like.
(2) It includes a case in which the electronic component is housed. The case may be one that is or is not partially open. Inside the case, one electronic component or more are housed.
(3) A shield layer having conductivity and magnetism is placed on at least part of a surface on an inner side of the case. The shield layer may be constituted by a single layer or may be composed of a plurality of layers. The surface on the inner side of the case is a surface other than an outer surface of a member placed on the outermost side out of members forming the case. Accordingly, an outward-facing surface of a member placed inside the case out of the members forming the case is also the surface on the inner side of the case.

According to this solution, since the shield layer having conductivity and magnetism is placed, the conductivity contributes to an improvement in a dV/dt characteristic (output characteristic), and at the same time, the magnetism contributes to an improvement in an EMC characteristic (influence by an electromagnetic wave), resulting in the achievement of the quality enhancement of the electronic component unit.

Further, according to this solution, since the shield layer is placed on the surface on the inner side of the case, it does not interfere with a member placed on the outer side of the case or the electronic component housed inside the case.

Further, according to this solution, placing the shield layer on the surface on the inner side of the case makes it possible to protect the shield layer by the case to maintain the effect of the shield layer for a longer period than placing the shield layer on the outer surface of the case.

Solution 2: An electronic component unit of this solution is the electronic component unit in any one of the above-described solutions, characterized in that the shield layer is a layer in which a first layer formed of a first material having the conductivity and a second layer formed of a second material having the magnetism are stacked.

In this solution, the shield layer is a layer in which a first layer formed of a first material having conductivity and a second layer formed of a second material having magnetism are stacked.

According to this solution, since the shield layer is constituted by a stack of the first layer and the second layer and thus is composed of two layers, it is possible to make the first layer and the second layer equal in thickness or different in thickness, making it possible to easily adjust the effect of the shield layer.

Solution 3: An electronic component unit of this solution is the electronic component unit in any one of the above-described solutions, characterized in that the shield layer is a layer formed of a mixed material in which a first material having the conductivity and a second material having the magnetism are mixed.

In this solution, the shield layer is a layer formed of a mixed material in which a first material having conductivity and a second material having magnetism are mixed.

According to this solution, since the shield layer is constituted by the single layer formed of the mixed material in which the first material and the second material are mixed, it is not necessary to form a plurality of layers, making it possible to easily manufacture the shield layer.

Solution 4: An electronic component unit of this solution is the electronic component unit in any one of the aforesaid solutions, characterized in that the first material is a carbon paste or a metal paste, and the second material is a magnetic paste.

This solution adds the following features.
(1) The first material is a carbon paste or a metal paste.
(2) The second material is a magnetic paste.

According to this solution, since the first material and the second material are pastes, it is possible to form the layers by coating, facilitating their manufacture and also achieving a cost reduction.

Solution 5: An electronic component unit of this solution is the electronic component unit in any one of the aforesaid solutions, characterized in that: the case includes a loop-shaped first member having an opening at a center, a second member formed to stand on an outer periphery of the first member, and a third member formed to stand on an inner periphery of the first member; and the shield layer is placed on at least one surface out of a first surface which is an inner side of the first member, a second surface which is an inner side of the second member, and a third surface which is an outer side of the third member.

This solution adds the following features.
(1) The case includes a loop-shaped first member having an opening at a center, a second member formed to stand on an outer periphery of the first member, and a third member formed to stand on an inner periphery of the first member.
(2) The shield layer is formed on at least one surface out of a first surface which is an inner side of the first member, a second surface which is an inner side of the second member, and a third surface which is an outer side of the third member.

According to this solution, since the shield layer is formed on at least one surface out of the first surface, the second surface, and the third surface, it is possible to place the shield layer on a wide range of the surface on the inner side of the case or place the shield layer on a limited range of the surface on the inner side of the case, enabling the efficient quality enhancement of the electronic component unit.

### [Effect of Invention]

According to the present invention, it is possible to enhance the quality of an electronic component unit.

### [Brief Description of Drawings]

[Fig. 1] Fig. 1 is a perspective view illustrating a current sensor 100 of this embodiment.
[Fig. 2] Fig. 2 is an exploded perspective view illustrating the current sensor 100 of this embodiment.
[Fig. 3A] Fig. 3A is a view illustrating a case 10 of a first type.
[Fig. 3B] Fig. 3B is a view illustrating the case 10 of the first type.
[Fig. 4A] Fig. 4A is a view illustrating a case 10 of a second type.
[Fig. 4B] Fig. 4B is a view illustrating the case 10 of the second type.
[Fig. 5A] Fig. 5A is a view illustrating a case 10 of a third type.
[Fig. 5B] Fig. 5B is a view illustrating the case 10 of the third type.
[Fig. 6A] Fig. 6A is a view illustrating a case 10 of a fourth type.
[Fig. 6B] Fig. 6B is a view illustrating the case 10 of the fourth type.
[Fig. 7A] Fig. 7A is a view illustrating a layer mode of a shield layer 50.
[Fig. 7B] Fig. 7B is a view illustrating a layer mode of the shield layer 50.
[Fig. 8] Fig. 8 is a chart illustrating evaluation samples of the shield layer 50.
[Fig. 9] Fig. 9 is a sectional view schematically illustrating a magnetic field measurement jig 200.
[Fig. 10] Fig. 10 is a chart illustrating the evaluation results of magnetic field coupling shielding characteristics.
[Fig. 11] Fig. 11 is a sectional view schematically illustrating an electric field measurement jig 300.
[Fig. 12] Fig. 12 is a chart illustrating the evaluation results of electric field coupling shielding characteristics.

### [Modes for Carrying out Invention]

Hereinafter, an embodiment of the present invention will be described with reference to the drawings.

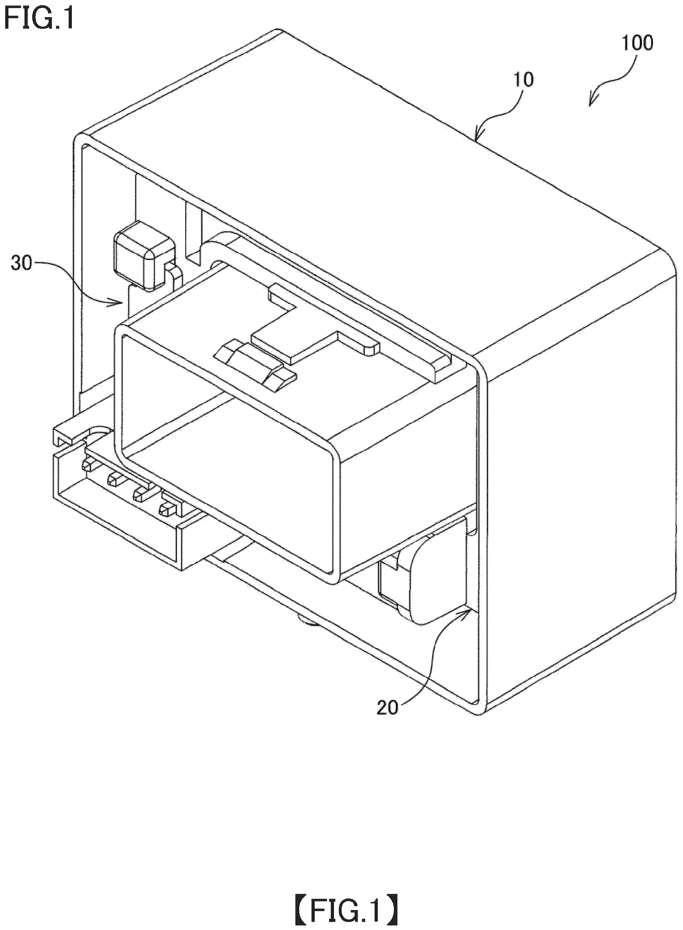

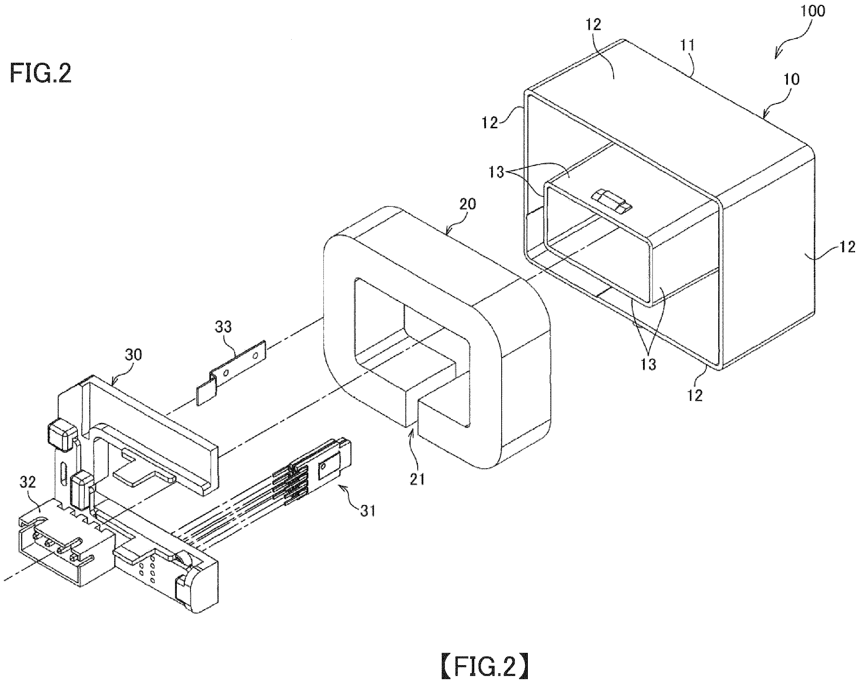

Fig. 1 is a perspective view illustrating a current sensor 100 of this embodiment. Fig. 2 is an exploded perspective view illustrating the current sensor 100 of this embodiment. Note that in some parts of the following drawings, an object is illustrated with its size or length being changed or exaggerated, or the illustration of an existing component is omitted.

As illustrated in Fig. 1, the current sensor 100 (electronic component unit), which is a sensor to measure a current, includes a case 10, a core 20 (electronic component), and a substrate 30 (electronic component).

The case 10 is a box-shaped member in which the core 20 and the substrate 30 are housed and has a through hole at its center. In the case 10, a part surrounding the through hole is open on the near side in the drawing and is not open on the far side in the drawing.

As illustrated in Fig. 2, in the case 10, the core 20 is housed, and the substrate 30 is housed while stacked on the core 20.

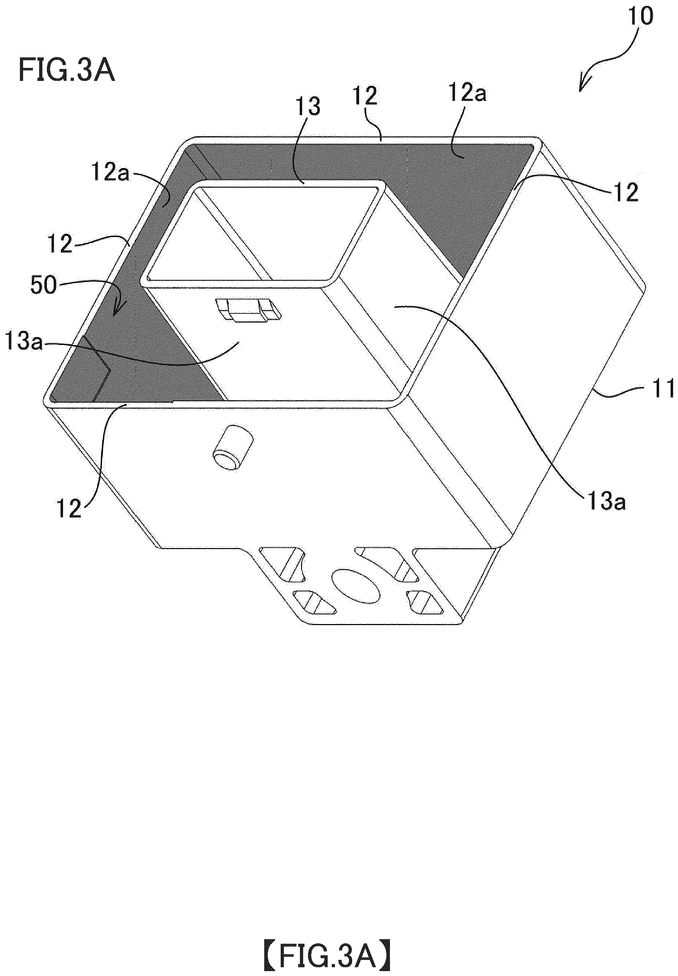

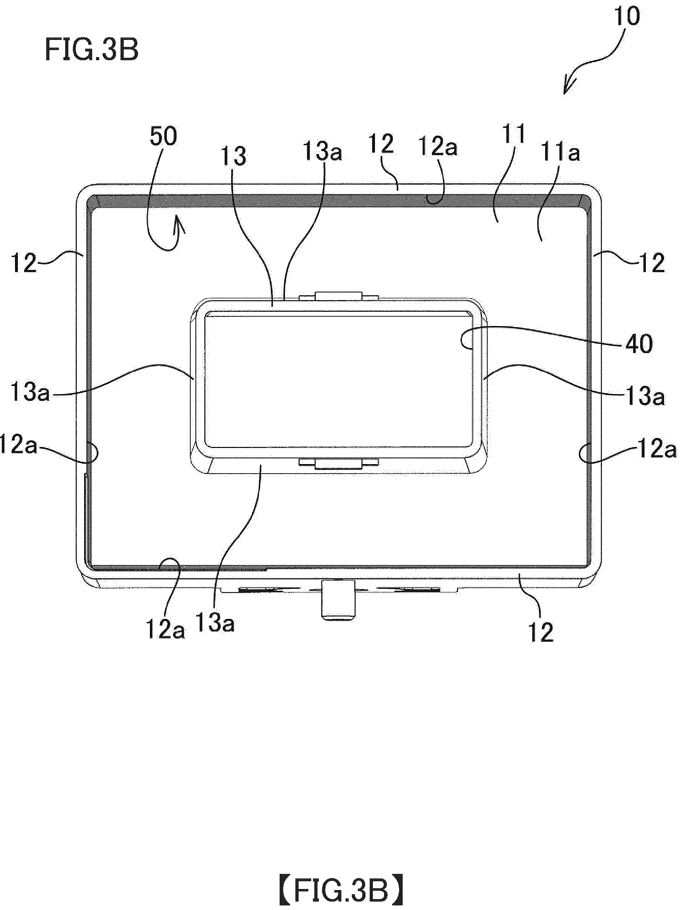

The case 10 includes a loop-shaped first member 11 having an opening 40 (see Figs. 3) at its center, a second member 12 formed to stand on the outer periphery of the first member 11, and a third member 13 formed to stand on the inner periphery of the first member 11.

The core 20 is a laminated core. In the state of having a not-illustrated primary conductor (busbar) inserted therein, the core 20 is capable of focusing a magnetic field generated by the passage of a primary current.

In the core 20, an air gap 21 is formed in at least one place in terms of the circumferential direction. In the air gap 21, a magnetic sensing element (a magneto-sensitive element, a magnetoelectric conversion element, or the like) such as a Hall element 31 is placed, and the Hall element 31 outputs a detection signal corresponding to the intensity of the magnetic field focused in the core 20.

The substrate 30 has a sideways U-shape so as to conform to the shape of a housing space of the case 10. On the substrate 30, the Hall element 31 is mounted and in addition, not-illustrated various components, IC chips, and so on are mounted to form a current detection circuit. The current detection circuit amplifies a voltage signal output from the Hall element 31 and performs various kinds of electrical processing to output a detected voltage.

An external connector 32 is mounted on the substrate 30, and the external connector 32 is placed such that it protrudes from the case 10 in the assembled state of the current sensor 100. The current sensor 100 is capable of supplying power to an output circuit through the external connector 32 and outputting the detected voltage from the current detection circuit.

### [dV/dt characteristic]

It has been known that in the current sensor 100, a stepwise voltage change in the primary conductor influences a change in the output signal (detected voltage). Specifically, it has been known that a steep voltage change of the primary current becomes noise to greatly influence the output signal, which is called a dV/dt characteristic of the current sensor 100 or the output signal. Such a dV/dt characteristic is considered to be due to noise transmission through a stray capacitance present between the primary conductor and the core 20 or the current detection circuit.

It is possible to reduce such an influence of the noise on the output signal by connecting the core 20 to a ground (GND) of the current detection circuit. This is because grounding the core 20 causes the noise component to be mostly absorbed to the ground side, making the transmission of the noise to the current detection circuit difficult. In this embodiment, the core 20 is connected to the ground of the current detection circuit through a plate-shaped nickel terminal 33 bonded to a surface (outer peripheral surface) of the core 20.

### [Shield Layer]

In this embodiment, a shield layer is placed in the current sensor 100 to improve two characteristics of the dV/dt characteristic and the EMC characteristic.

The shield layer is a layer placed on at least part of a surface on the inner side of the case 10 and having conductivity and magnetism.

Here, the dV/dt characteristic, which is as described above, is a characteristic of noise caused by electric field coupling between the primary conductor (busbar) and the current detection circuit (sensor circuit, ASIC, or the like). Further, the EMC characteristic is a characteristic of noise due to an electromagnetic wave input from the outside of the current sensor 100 or an electromagnetic wave emitted to the outside of the current sensor 100.

To improve the dV/dt characteristic and to improve the EMC characteristic, separate measures need to be taken because they are different phenomena. To take the separate measures, in this embodiment, two kinds of pastes (a carbon paste and a magnetic paste) are applied on the surface on the inner side of the case 100 to form the shield layer.

A part where to place the shield layer can differ depending on placement locations or performance of the electronic components inside the current sensor 100, the size or shape of the case 10, or a placement location or performance of the primary conductor. In this embodiment, any of the following four types is adoptable. These types will be explained in order below.

### [First Type]

Figs. 3 are views illustrating a case 10 of a first type, Fig. 3A being its perspective view and FIG. 3B being its front view.

In the first type, the shield layer 50 is placed on a second surface 12a which is the inner side of the second member 12 (in the drawings, a member forming a side surface (periphery) of the case 10) of the case 10.

According to the first type, it is possible to reduce an influence from the side surface side of the case 10.

### [Second Type]

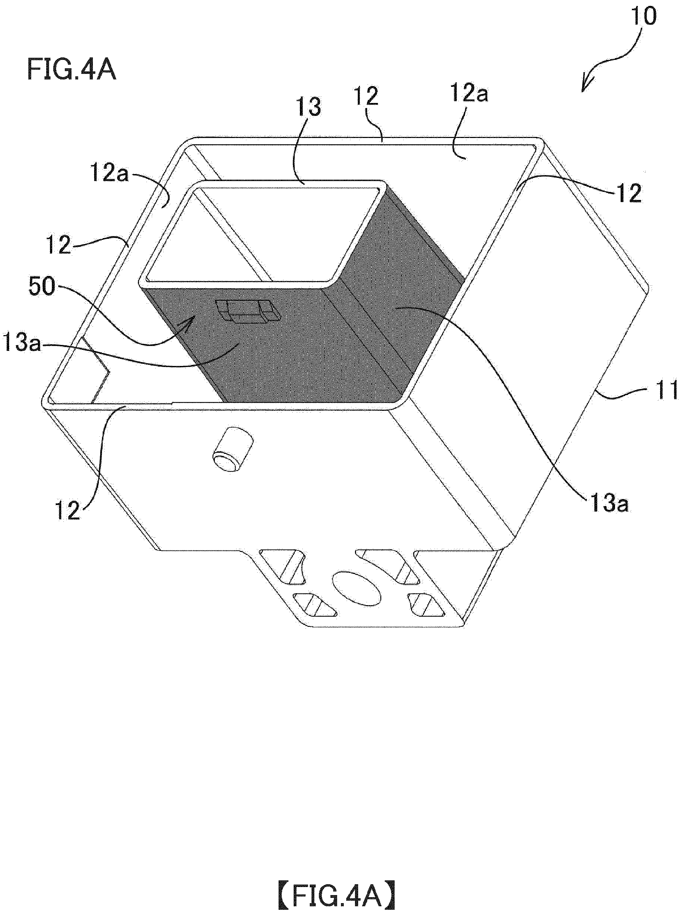

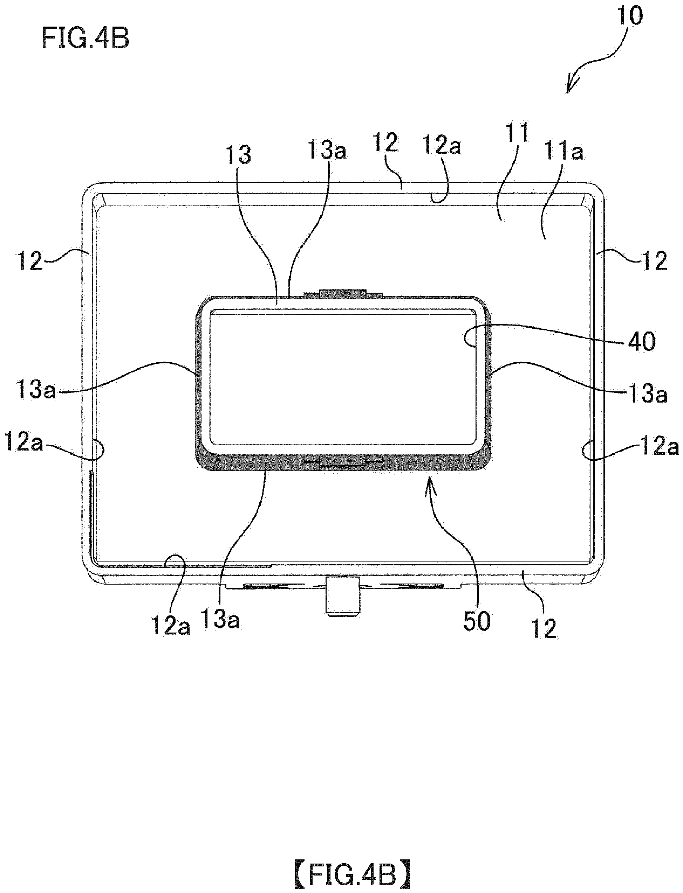

Figs. 4 are views illustrating a case 10 of a second type, Fig. 4A being its perspective view and Fig. 4B being its front view.

In the second type, the shield layer 50 is placed on a third surface 13a which is the outer side of the third member 13 (a member forming the through hole) of the case 10.

According to the second type, it is possible to reduce an influence from the primary conductor (busbar) placed at the center of the case 10.

### [Third Type]

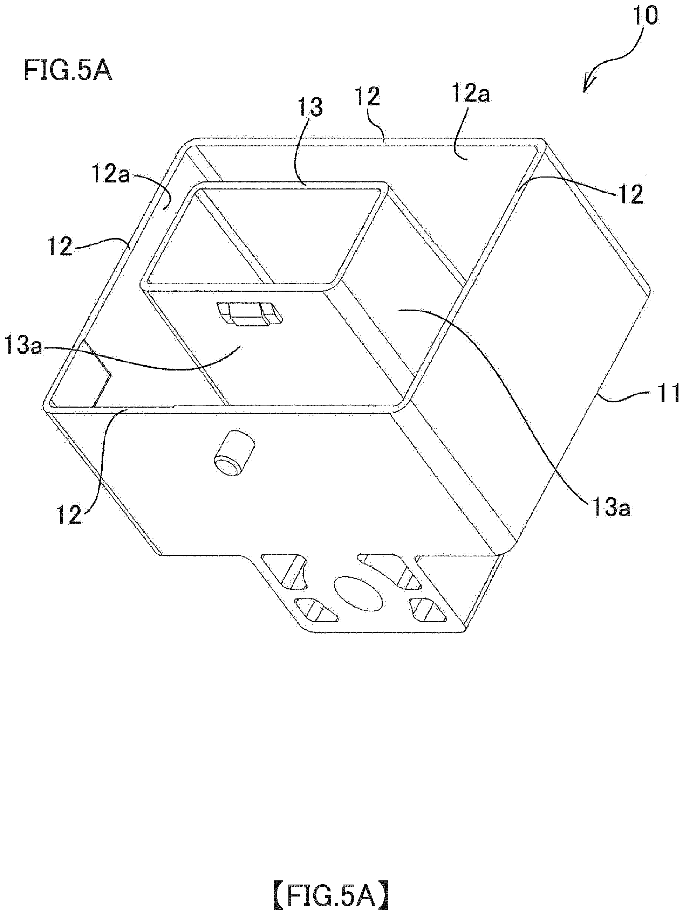

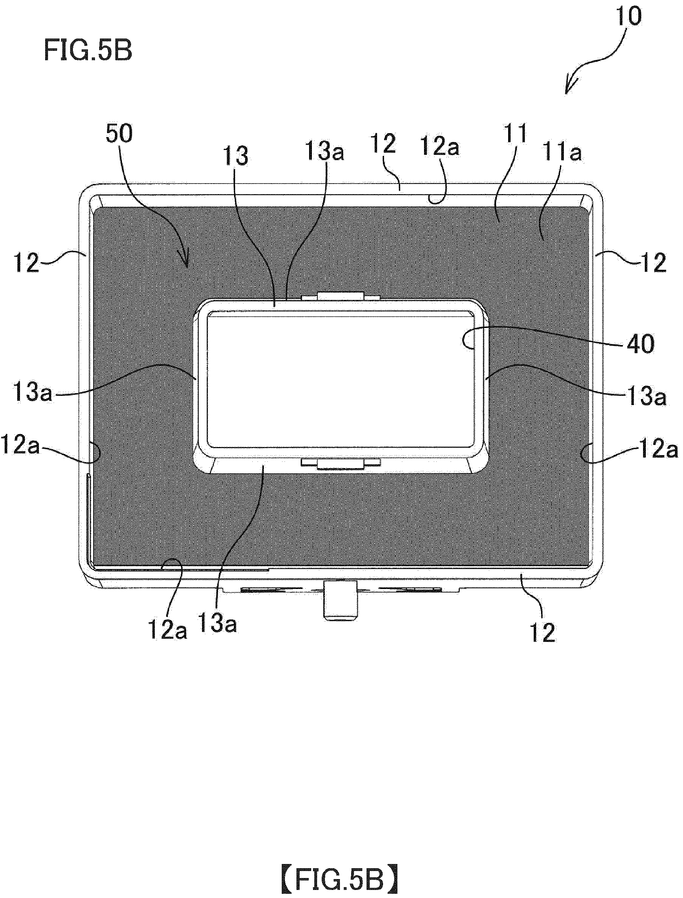

Figs. 5 are views illustrating a case 10 of a third type, Fig. 5A being its perspective view and Fig. 5B being its front view.

In the third type, the shield layer 50 is placed on a first surface 11a which is the inner side of the first member 11 (in the drawing, a member forming a bottom surface) of the case 10.

According to the third type, it is possible to reduce an influence from the bottom surface side of the case 100.

### [Fourth Type]

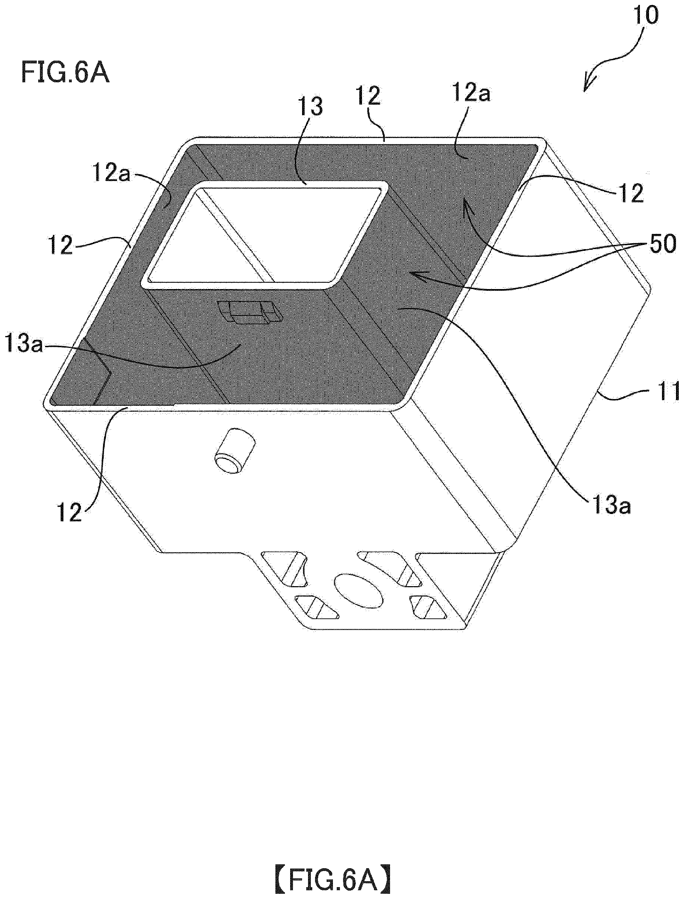

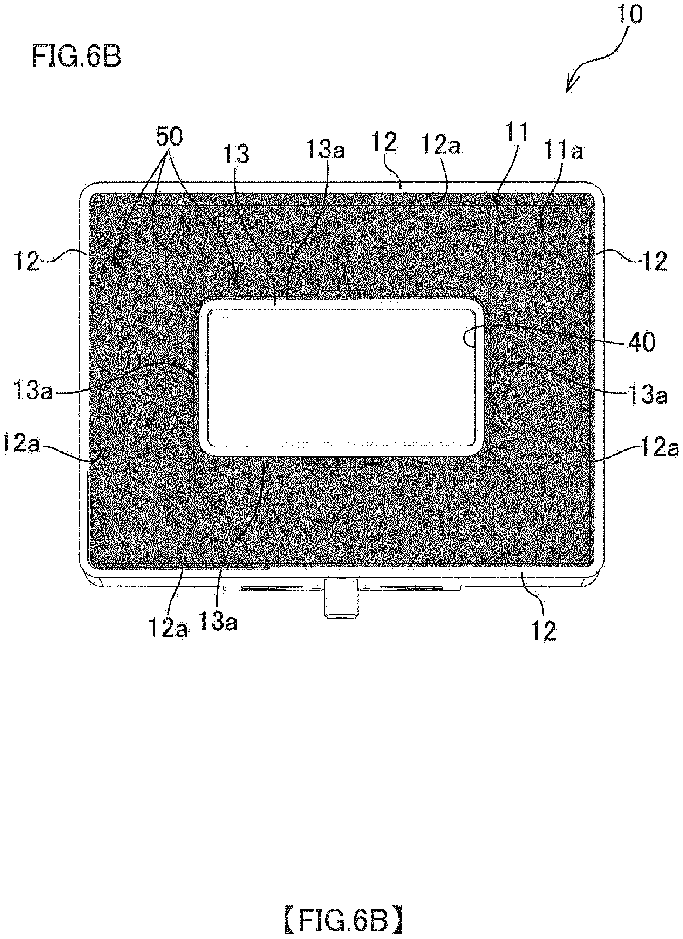

Figs. 6 are views illustrating a case 10 of a fourth type, Fig. 6A being its perspective view and Fig. 6B being its front view.

In the fourth type, which is a combined type of all of the first type to the third type, the shield layer 50 is placed on the first surface 11a, the second surface 12a, and the third surface 13a of the case 10.

According to the fourth type, it is possible to reduce all of the influence from the side surface side of the case 10, the influence from the primary conductor (busbar) placed at the center of the case 10, and the influence from the bottom surface side of the case 10.

Any combination of two types out of the first type to the third type is usable. Further, in the first type to the fourth type, the shield layer 50 may be placed on at least part of the first surface 11a, the second surface 12a, or the third surface 13a.

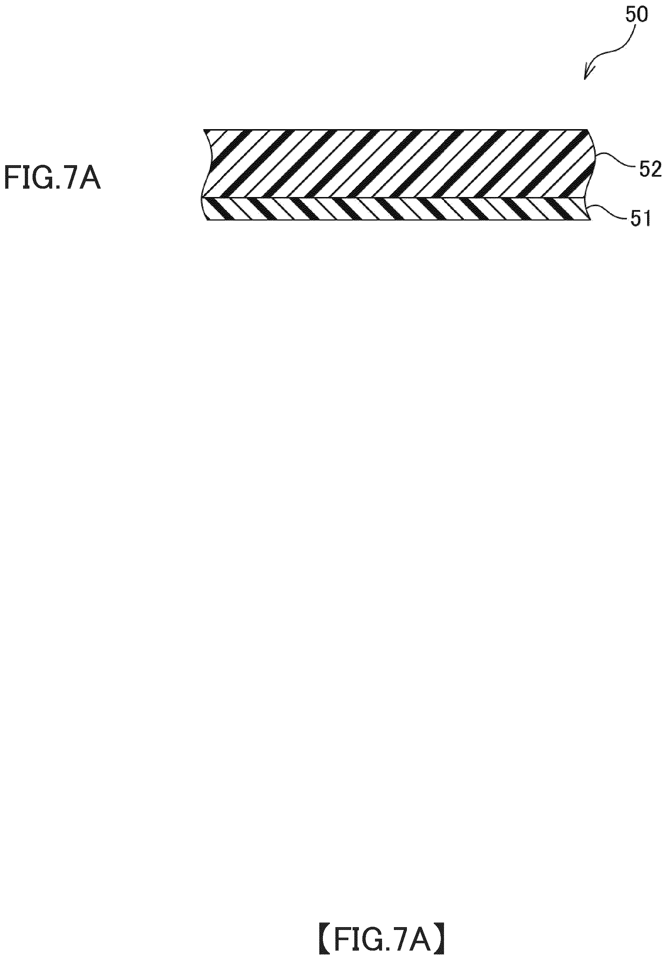

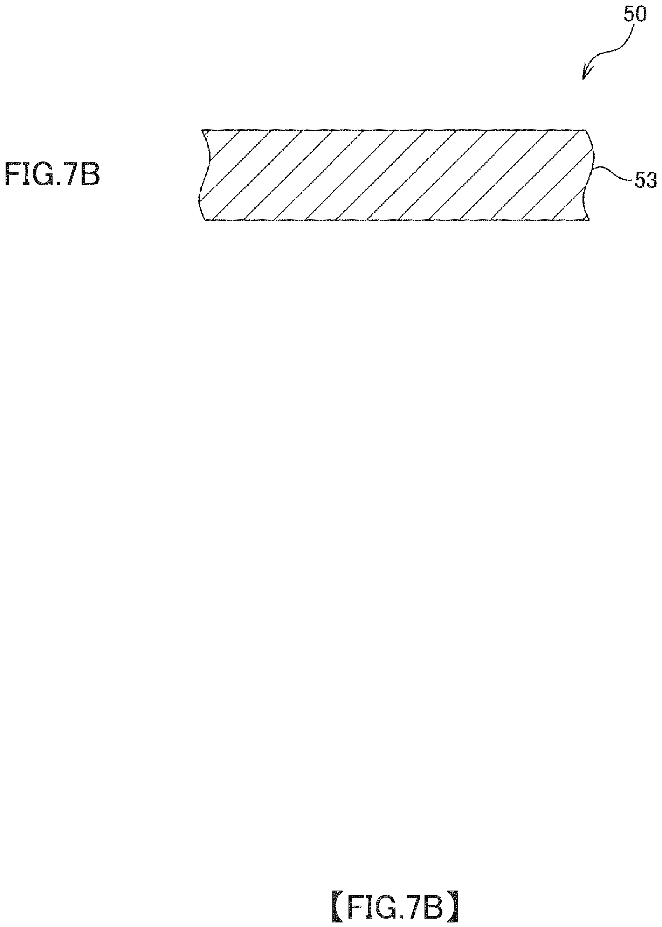

Figs. 7 are views illustrating layer modes of the shield layer 50.

As the shield layer 50, a first mode illustrated in Fig. 7A or a second mode illustrated in Fig. 7B is adoptable.

### [First Mode]

As illustrated in Fig. 7A, the shield layer 50 is composed of two layers. Specifically, the shield layer 50 is constituted by a layer in which a carbon paste layer 51 (first layer) formed of a carbon paste (first material) having conductivity and a magnetic paste layer 52 (second layer) formed of a magnetic paste (second material) having magnetism are stacked.

With the case 10, the carbon paste layer 51 may be in contact, or the magnetic paste layer 52 may be in contact. Further, the carbon paste layer 51 and the magnetic paste layer 52 may be equal in thickness or may be different in thickness.

### [Second Mode]

As illustrated in Fig. 7B, the shield layer 50 is constituted by a single layer. Specifically, the shield layer 50 is constituted by a mixed layer 53 formed of a mixed material in which the carbon paste (first material) having conductivity and the magnetic paste (second material) having magnetism are mixed.

The carbon paste is a coating material in which carbon particles are added to a resin. The carbon paste improves the dV/dt characteristic and the EMC characteristic (improves electric field coupling of electromagnetic waves, and in magnetic field coupling as well, it improves a shielding characteristic for frequencies of 500 MHz or higher).

The magnetic paste is a coating material in which powder of a magnetic material is added to a resin. The magnetic paste improves the EMC characteristic (improves magnetic field coupling of electromagnetic waves, in particular, improves a low-frequency side characteristic in magnetic field coupling better than a carbon paste and a metal paste).

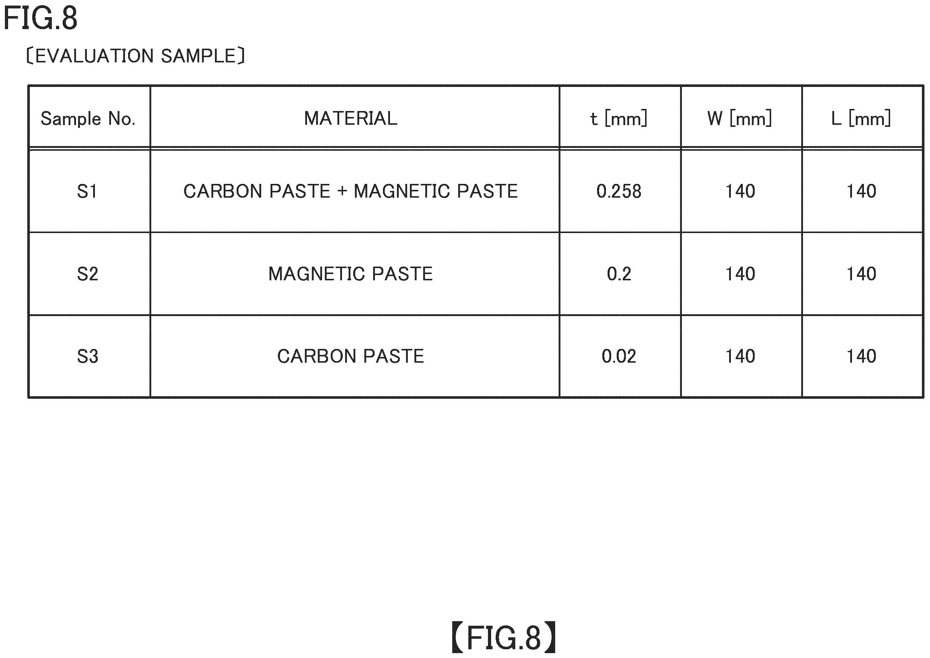

Fig. 8 is a chart illustrating evaluation samples of the shield layer 50.

A material of an evaluation sample S1 is a carbon paste and a magnetic paste. The evaluation sample S1 has a thickness t of 0.258 mm, a lateral length W of 140 mm, and a longitudinal length L of 140 mm. The evaluation sample S1 may be in the first mode illustrated in Fig. 7A, or may be in the second mode illustrated in Fig. 7B.

A material of an evaluation sample S2 is a magnetic paste. The evaluation sample S2 has a thickness t of 0.2 mm, a lateral length W of 140 mm, and a longitudinal length L of 140 mm.

A material of an evaluation sample S3 is a carbon paste. The evaluation sample S3 has a thickness t of 0.02 mm, a lateral length W of 140 mm, and a longitudinal length L of 140 mm.

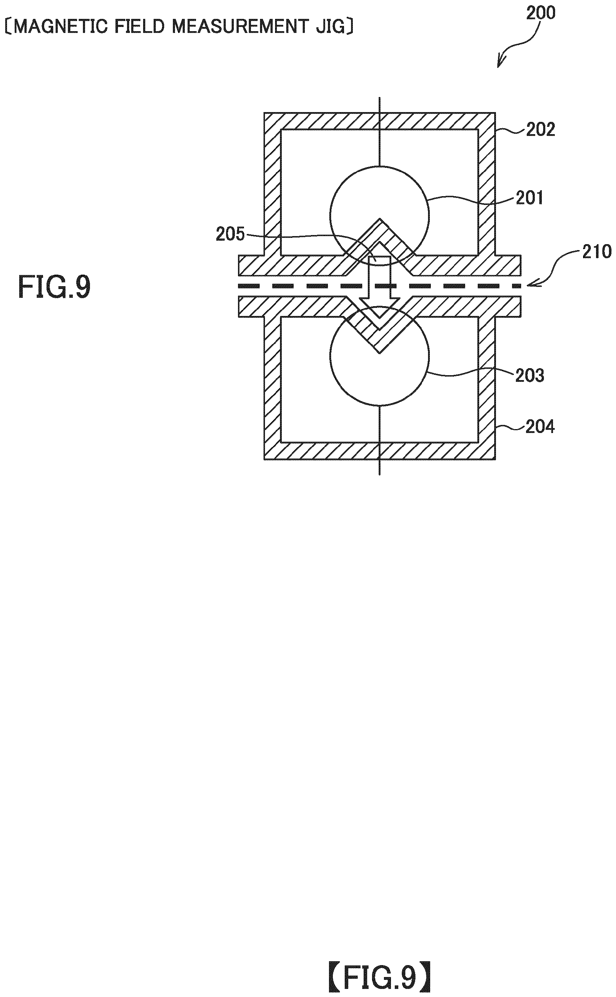

Fig. 9 is a sectional view schematically illustrating a magnetic field measurement jig.

The magnetic field measurement jig 200 includes an upper case 202 housing a transmitting antenna 201 and a lower case 204 housing a receiving antenna 203 and is capable of generating a magnetic field 205 from the transmitting antenna 201 toward the receiving antenna 203.

Then, it is capable of measuring a magnetic field coupling shielding characteristic, with an evaluation sample 210 being placed between the upper case 202 and the lower case 204.

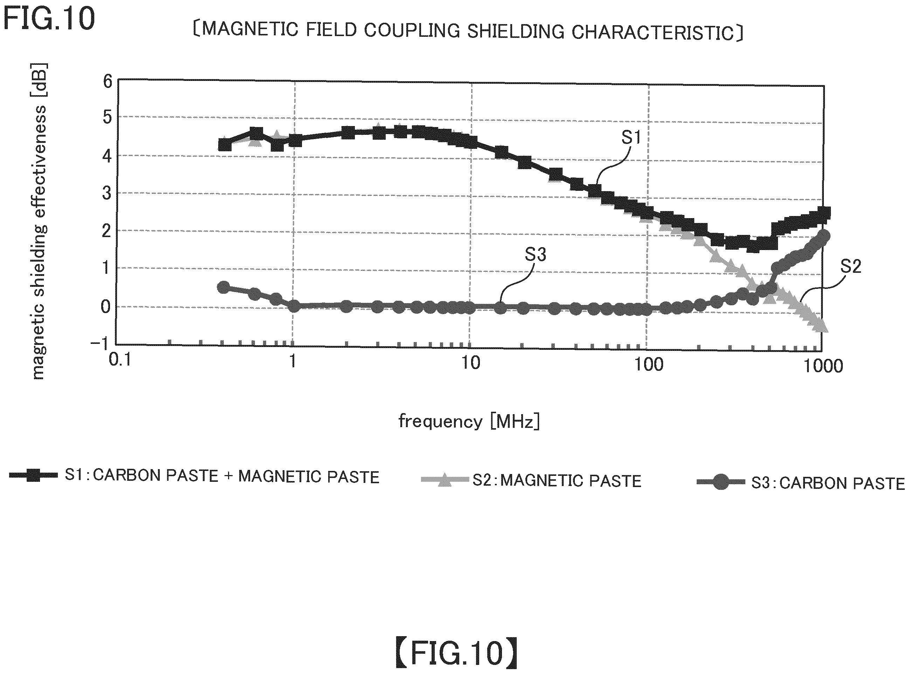

Fig. 10 is a chart illustrating the evaluation results of the magnetic field coupling shielding characteristics.

Specifically, the three evaluation samples S1 to S3 listed in Fig. 8 were placed on the magnetic field measurement jig in Fig. 9, and electromagnetic wave shielding was evaluated (magnetic field coupling) by a KEC method. Note that the KEC method is a method of evaluating an attenuation amount of a signal on a receiving side, with an evaluation sample being inserted between a jig on a transmitting side and a jig on the receiving side.

The vertical axis in the drawing represents magnetic shielding effectiveness [dB], and a higher numerical value indicates higher magnetic shielding effectiveness.

The horizontal axis in the drawing represents frequency [MHz].

### [Evaluation Sample S1]

The evaluation sample S1 is a sample formed of the carbon paste and the magnetic paste.

The evaluation sample S1 stably has high magnetic shielding effectiveness over a range from a low frequency up to a high frequency.

Specifically, the evaluation sample S1 exhibits a value of 4.2 dB at 0.4 MHz and exhibits similar values over a range up to 10.0 MHz, and the value gently decreases over a range from this point up to 300 MHz, but the value starts to increase at around 500 MHz.

### [Evaluation Sample S2]

The evaluation sample S2 is a sample formed of the magnetic paste.

The evaluation sample S2 has high magnetic shielding effectiveness in low frequencies but has low magnetic shielding effectiveness in high frequencies.

Specifically, the evaluation sample S2 exhibits a value of 4.2 dB at 0.4 MHz and exhibits similar values over a range up to 10.0 MHz, and the value gradually decreases over a range from this point up to 1000 MHz, and the value does not increase in high frequencies.

### [Evaluation Sample S3]

The evaluation sample S3 is a sample formed of the carbon paste.

The evaluation sample S3 has low magnetic shielding effectiveness in low frequencies but has high magnetic shielding effectiveness in high frequencies.

Specifically, the evaluation sample S3 exhibits a value of 0.6 dB at 0.4 MHz, the value gently decreases over a range from this point up to 1.0 MHz, similar values are exhibited over a range from 1.0 MHz up to around 110.0 MHz, and the value gradually increases over a range from this point up to 1000 MHz.

The evaluation sample S1 thus has the characteristic having the merits of both the evaluation sample S2 and the evaluation sample S3. As the shield layer 50 of the current sensor 100, the shield layer 50 having the same composition as that of the evaluation sample S1 is adopted.

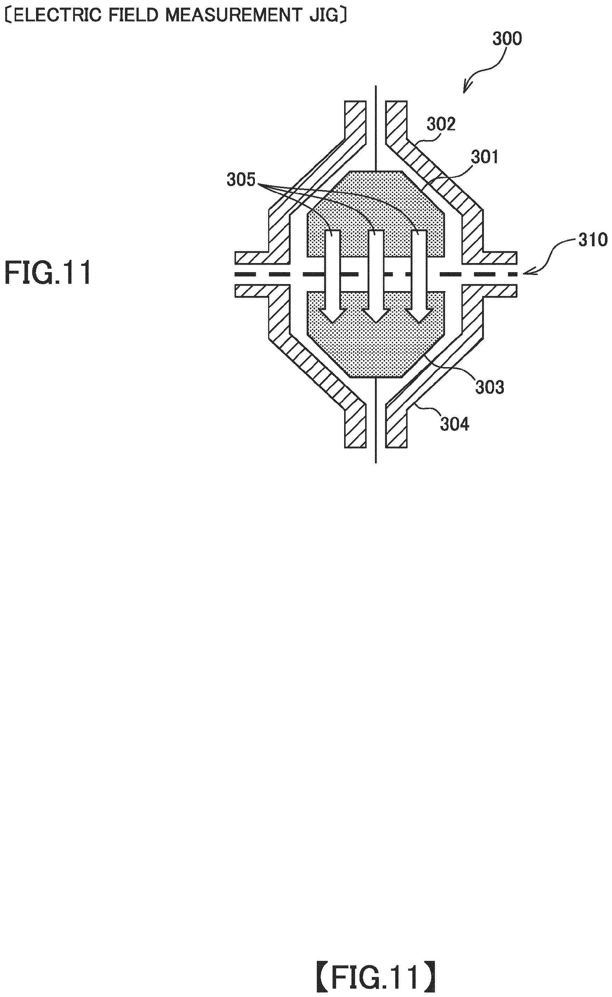

Fig. 11 is a sectional view schematically illustrating an electric field measurement jig.

The electric field measurement jig 300 includes an upper case 302 housing a transmitting antenna 301 and a lower case 304 housing a receiving antenna 303 and is capable of generating electric fields 305 from the transmitting antenna 301 toward the receiving antenna 303.

Then, it is capable of measuring an electric field coupling shielding characteristic, with an evaluation sample 310 being placed between the upper case 302 and the lower case 304.

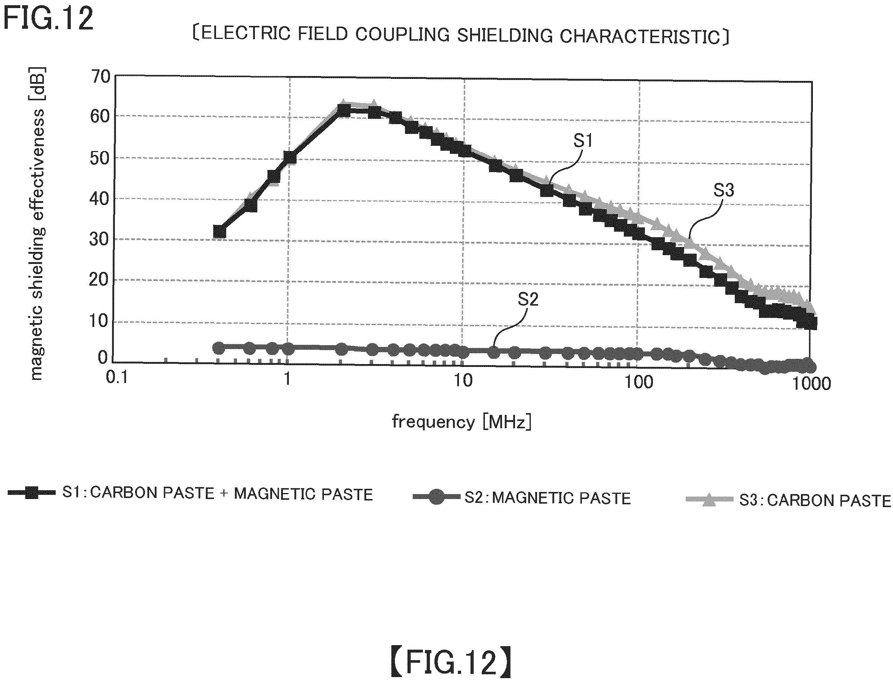

Fig. 12 is a chart illustrating the evaluation results of the electric field coupling shielding characteristics.

Specifically, the three evaluation samples S1 to S3 listed in Fig. 8 were placed on the electric field measurement jig in Fig. 11, and electromagnetic wave shielding was evaluated (electric field coupling) by the KEC method.

The vertical axis in the drawing represents magnetic shielding effectiveness [dB], and a higher numerical value indicates higher magnetic shielding effectiveness.

The horizontal axis in the drawing represents frequency [MHz].

### [Evaluation Sample S1]

The evaluation sample S1 is a sample formed of the carbon paste and the magnetic paste.

As for the evaluation sample S1, a value starts to gradually increase at a low frequency and gradually decreases after reaching the peak.

Specifically, the evaluation sample S1 exhibits a value of 32.0 dB at 0.4 MHz, the value gradually increases until it reaches around 60.0 dB at 2.0 MHz, and from this point, the value gradually decreases until it reaches around 10.0 dB at 1000.0 MHz.

### [Evaluation Sample S2]

The evaluation sample S2 is a sample formed of the magnetic paste.

The evaluation sample S2 has low magnetic shielding effectiveness as a whole.

Specifically, the evaluation sample S2 exhibits a value of 3.0 dB at 0.4 MHz and exhibits similar values over a range up to around 1000.0 MHz.

### [Evaluation Sample S3]

The evaluation sample S3 is a sample formed of the carbon paste.

The evaluation sample S3 mostly exhibits similar values to those exhibited by the evaluation sample S1.

The evaluation sample S1 thus dominantly has the characteristic of the evaluation sample S3 (is greatly influenced by the carbon paste) without receiving the inferior part of the characteristic of the evaluation sample S2 (the characteristic that the magnetic paste does not exhibit a very high effect in electric field coupling). Note that, as the shield layer 50 of the current sensor 100, the shield layer 50 having the same composition as the evaluation sample S1 is adopted as described above.

Adopting such a composite material of the carbon paste and the magnetic paste for the shield layer 50 enables the improvement in the magnetic field coupling and electric field coupling shielding characteristics.

As has been described hitherto, this embodiment has the following effects.
(1) According to this embodiment, since the shield layer 50 having conductivity and magnetism is placed, the conductivity contributes to the improvement in the dV/dt characteristic (output characteristic) and, at the same time, the magnetism contributes to the improvement in the EMC characteristic (the influence by the electromagnetic wave), resulting in the achievement of the quality enhancement of the current sensor 100.
(2) According to this embodiment, since the shield layer 50 is placed on the surface on the inner side of the case 10, it does not interfere with a member placed on the outer side of the case 10 or the electronic components housed inside the case 10.
(3) According to this embodiment, placing the shield layer 50 on the surface on the inner side of the case 10 makes it possible to protect the shield layer 50 by the case 10, and involves a lower possibility of deterioration or breakage of the shield layer 50 to make it possible to maintain the effect of the shield layer 50 for a longer period than placing the shield layer 50 on a surface on the outer side of the case 10.
(4) According to this embodiment, since the shield layer 50 is constituted by a stack of the carbon paste layer 51 and the magnetic paste layer 52 and thus is composed of two layers, it is possible to make the carbon paste layer 51 and the magnetic paste layer 52 equal in thickness or different in thickness, making it possible to easily adjust the effect of the shield layer 50 (for example, only a layer whose effect is desired to be increased can be made thick).
(5) According to this embodiment, since the shield layer 50 is constituted by a single layer formed of the mixed material in which the carbon paste and the magnetic paste are mixed, it is not necessary to form a plurality of layers, making it possible to easily manufacture the shield layer 50.
(6) According to this embodiment, since the carbon paste and the magnetic paste are pastes (coating materials), the layers can be formed by coating, facilitating their manufacture and also achieving a cost reduction.
(7) According to this embodiment, since the shield layer 50 is formed on at least one surface out of the first surface 11a, the second surface 12a, and the third surface 13a, it is possible to place the shield layer 50 on a wide range of the surface on the inner side of the case 10 or place the shield layer 50 on a limited range of the surface on the inner side of the case 10, enabling the efficient quality enhancement of the current sensor 100.
(8) The use of a metal or a typical molded product to improve the dV/dt characteristic and the EMC characteristic complicates the structure, leading to a cost increase. Therefore, in this embodiment, various pastes (the carbon paste and the magnetic paste) are adopted for the shield layer 50. Capable of freely coating a desired place, the pastes can form an optimum shielding structure, making it possible to easily improve both the dV/dt characteristic and the EMC characteristic. Further, adding the magnetic paste also enables the shielding of a radio noise band (a frequency band of around 0.1 to 5.0 MHz). Further, being formed of the pastes, the shield layer 50 can be formed at a lower cost than a metal shield (film by vacuum deposition such as vapor deposition or sputtering).

### [Modifications]

The present invention is not limited to the above-described embodiment and can be embodied in various modified forms.
(1) In the description, the current sensor is taken as an example of the electronic component unit, but the electronic component unit may be an electronic component unit other than the current sensor (for example, a gate driver, a power supply module, an LED driver, a transformer, a reactor, a mobile information terminal, a mobile phone, a charger, or the like).
(2) In the description of the above embodiment, the shield layer formed of the carbon paste and the magnetic paste is taken as an example, but this combination is not limiting, and the current sensor (electronic component unit) may be one in which two kinds of pastes or more are applied on the surface on the inner side of the case. The combination of two kinds of pastes or more can be as follows.
   (ex. 1) a carbon paste, a magnetic paste, an insulating paste
   (ex. 2) a carbon + magnetic paste (a paste having conductivity and magnetism), an insulating paste
   (ex. 3) a carbon + metal paste (a paste formed of a mixture of different materials and having conductivity), a magnetic paste, an insulating paste
   (ex. 4) a metal paste, a magnetic paste, a carbon paste, an insulating paste
   Note that the insulating paste in each example is optional.
(3) A shield layer for improving the dV/dt characteristic and a shield layer for improving the EMC characteristic may be applied on different places. Note that in the case where they are applied on the same place, a paste formed of a mixture of powders having different properties may be applied or different pastes can be applied in two layers (see Figs. 7).
(4) The material forming the shield layer may be mixed in the case instead of being applied on the surface on the inner side of the case.
(5) The first material may be a metal paste.
(6) The mounting of the nickel terminal 33 is optional.
(7) In the case where the dV/dt characteristic is improved using the carbon paste (carbon) and the EMC characteristic is improved using the magnetic paste, there may be a part where only one of these materials is applied, instead of these materials being applied in two layers. In this case, the following modes are adoptable.
   (a) In the case where the first type illustrated in Figs. 3 and the second type illustrated in Figs. 4 are combined, the carbon paste and the magnetic paste can be applied in two layers on the position of the shield layer 50 of the first type, and only the carbon paste or the magnetic paste can be applied on the position of the shield layer 50 of the second type. Note that these types can be combined as desired, and which one of the types has two layers and which one of the types has a single layer can be set as desired.
   (b) In the case of the first type illustrated in Figs. 3, the carbon paste and the magnetic paste can be applied in two layers on a partial region of the region where the shield layer 50 of the first type is placed and only the carbon paste or the magnetic paste can be applied on the other region. This also applies to the other types.

Note that (a) and (b) can be adopted in combination.

The Hall element 31 may be replaced by an element that detects a magnetic field to vary the output, such as a GMR (Giant Magneto Resistive) element or a TMR (Tunnel Magneto Resistance) element.

### [Industrial Availability]

According to the present invention, it is possible to enhance the quality of an electronic component unit.

### [Explanation of Reference Signs]

10 case
11 first member
11a first surface
12 second member
12a second surface
13 third member
13a third surface
20 core
21 air gap
30 substrate
31 Hall element
32 external connector
33 nickel terminal
40 opening
50 shield layer
51 carbon paste layer
52 magnetic paste layer
53 mixed layer
100 current sensor
200 magnetic field measurement jig
300 electric field measurement jig

## Claims

1. An electronic component unit (100) comprising:
an electronic component (20, 30);
a case (10) in which the electronic component (20, 30) is housed; and
a shield layer (50) placed on at least part of a surface on an inner side of the case (10) and having conductivity and magnetism.

2. The electronic component unit according to claim 1, **characterized in that**
the shield layer (50) is a layer in which a first layer (51) formed of a first material having the conductivity and a second layer (52) formed of a second material having the magnetism are stacked.

3. The electronic component unit according to claim 1, **characterized in that**
the shield layer (50) is a layer (53) formed of a mixed material in which a first material having the conductivity and a second material having the magnetism are mixed.

4. The electronic component unit according to claim 2 or 3, **characterized in that**:
the first material is a carbon paste or a metal paste; and
the second material is a magnetic paste.

5. The electronic component unit according to claim 1, **characterized in that**:
the case (10) includes a loop-shaped first member (11) having an opening (40) at a center, a second member (12) formed to stand on an outer periphery of the first member (11), and a third member (13) formed to stand on an inner periphery of the first member (11); and
the shield layer (50) is placed on at least one surface out of a first surface (11a) which is an inner side of the first member (11), a second surface (12a) which is an inner side of the second member (12), and a third surface (13a) which is an outer side of the third member (13).
